Europäisches Patentamt

European Patent Office

Office européen des brevets

(11) Veröffentlichungsnummer : **0 022 202**
**B1**

(12) **EUROPÄISCHE PATENTSCHRIFT**

(45) Veröffentlichungstag der Patentschrift :
17.03.82

(21) Anmeldenummer : **80103472.9**

(22) Anmeldetag : **21.06.80**

(51) Int. Cl.³ : **H 01 L 29/74, H 01 L 29/06**

(54) **Thyristor und Verfahren zu seiner Herstellung.**

(30) Priorität : **03.07.79 DE 2926734**

(43) Veröffentlichungstag der Anmeldung :
**14.01.81 (Patentblatt 81/02)**

(45) Bekanntmachung des Hinweises auf die Patenterteilung : **17.03.82 Patentblatt 82/11**

(84) Benannte Vertragsstaaten :
**FR GB IT NL**

(56) Entgegenhaltungen :
**DE - A - 1 514 727**
**DE - A1 - 2 837 394**
**US - A - 4 016 593**

**SOLID-STATE ELECTRONICS, Band 11, 1968**
**Oxford**
**S. SCHÄFER « Herstellung von p-n-Übergängen**
**durch gemeinsame plastische Verformung von p-**
**und n-dotiertem Germanium » Seiten 675-681**

(73) Patentinhaber : **Licentia Patent-Verwaltungs-GmbH**
**Theodor-Stern-Kai 1**
**D-6000 Frankfurt/Main 70 (DE)**

(72) Erfinder : **Dahlberg, Reinhard, Dr.**
**Innere Bergstrasse 32**
**D-7101 Flein (DE)**

(74) Vertreter : **Maute, Hans-Jürgen, Dipl.-Ing.**
**Licentia Patent-Verwaltungs-GmbH Theo-**
**dor-Stern-Kai 1**
**D-6000 Frankfurt/Main 70 (DE)**

## Thyristor und Verfahren zu seiner Herstellung

Die Erfindung beschreibt einen Thyristor, bei welchem der mittlere der drei p/n-Übergänge einer p/n/p/n-Struktur durch plastische Verformung hergestellt ist.

Thyristoren werden in großem Umfang in der Elektronik und vor allem in der Leistungselektronik eingesetzt. Für Starkstrom-Anwendungen stehen heute Thyristoren mit Schaltleistungen im Megawatt-Bereich zur Verfügung. Besonders zuverlässig bei hohen Spannungen arbeiten Thyristoren mit Licht-Zündung, weil sie keine elektrische Zündelektrode benötigen. Als Lichtquelle für die Zündung dient meist eine Infrarot-Leuchtdiode aus GaAs. Die Frequenzgrenze dieser Thyristoren liegt im allgemeinen etwa in der Gegend von einigen kHz.

Der Erfindung liegt die Aufgabe zugrunde, hochfrequente Thyristoren anzugeben, die für Licht-Zündung und konventionelle Zündung bei gleichzeitig großer Leistung besonders geeignet sind.

Diese Aufgabe wird bei einem Thyristor erfindungsgemäß dadurch gelöst, daß eine n-dotierte und eine p-dotierte einkristalline Halbleiterscheibe vorgesehen sind, daß eine Seite beider Scheiben eine Zone von jeweils umgekehrtem Leitfähigkeitstyp trägt, daß beide Halbleiterscheiben auf einer ihrer beiden Seiten eine Struktur mit parallel zueinander verlaufenden Wällen aufweisen, und daß die beiden Halbleiterscheiben mit ihren strukturierten Seiten unter Bildung einer pnpn-Zonenfolge so zusammengesetzt sind, daß die Wälle beider Halbleiterscheiben sich kreuzen und berühren, und daß die Berührungsflächen infolge plastischer Verformungen des Halbleitergitters elektrisch parallel geschaltete p/n-Übergänge bilden.

Die Halbleiterscheiben werden zur Herbeiführung der erforderlichen plastischen Verformungen an den Berührungsflächen vorzugsweise unter mechanischem Druck bei erhöhter Temperatur zusammengepreßt.

Das Prinzip der gekreuzten parallelen Wälle wird bereits in der DE-A-25 47 262 beschrieben. Die Ausbildung dieses Prinzips als Thyristor wird dabei jedoch nicht erwähnt.

Durch die Veröffentlichung (1) ist es bekannt, p/n-Übergänge dadurch zu erzeugen, daß man einen p- und einen n-Kristall aus Silizium oder Germanium bei höherer Temperatur und unter Druck gemeinsam verformt. Sofern der Verformungsgrad nicht größer als $\sim 3\%$ ist (Versetzungsdichte kleiner $10^6/cm^2$), lassen sich nach dieser Methode p/n-Übergänge mit guten elektrischen Eigenschaften herstellen.

Wenn die Anzahl der parallel zueinander verlaufenden Wälle auf jeder Halbleiterscheibe N ist, dann werden auf die beschriebene Weise $N^2$ elektrisch parallel geschaltete p/n-Übergänge zwischen den beiden Halbleiterscheiben gebildet. Diese p/n-Übergänge haben eine ähnlich gute Wärmeableitung wie kleinflächige Kontakte zwischen zwei Körpern. Bekanntlich steigen die erlaubten Leistungsdichten $P = [Watt/cm^2]$ in einem solchen Kontakt proportional mit $1/2D$, wenn $2D$ Durchmesser des Kontaktes ist. Auch die Leistungsdichte (bei konstanter Junction-Temperatur) in den $N^2$ parallel geschalteten p/n-Übergängen nimmt (für Fluß- und Sperrichtung) mit $1/2D$ zu, wenn $2D$ der Durchmesser eines p/n-Überganges ist. Wenn bei einer bestimmten äußeren Kühlung an den Anschlüssen eines konventionellen Thyristors mit $1\ cm^2$ Fläche die gerade noch zulässige Leistungsdichte $P \sim 50\ Watt/cm^2$ beträgt, dann ist die analog zulässige Leistungsdichte in einem Kontakt mit dem Durchmesser $2D = 1 \cdot 10^{-3}\ cm$ ca. $P \sim 50$ Kilowatt/cm². Das heißt, daß der Junction-Wärmewiderstand des Thyristors gemäß der Erfindung vernachlässigbar gegenüber den anderen Wärmewiderständen der Anordnung ist.

Die Struktur mit den Wällen auf einer Seite der Halbleiterscheiben 1 und 2 kann in an sich bekannter Weise mit Hilfe eines chemischen, elektrochemischen oder Plasma-Ätzprozesses hergestellt werden. Auch durch Strukturätzen z.B. in eine 100-Fläche einer einkristallinen Siliziumscheibe lassen sich Wälle erzeugen, die sich beidseitig mit einem Böschungswinkel von ca. 54° zur freiliegenden Stirnfläche hin verjüngen.

Die Struktur mit den Wällen kann aber auch mechanisch, z.B. durch Sägen, hergestellt werden.

Die Zone vom umgekehrten Leitfähigkeitstyp kann über einen Eindiffusionsprozeß, über Ionenimplantation oder über einen Epitax-Prozeß in an sich bekannter Weise entstanden sein.

Die beiden Halbleiterscheiben tragen auf ihrer zweiten Oberflächenseite einen sperrfreien Kontakt.

Nach der Umwandlung der Berührungsflächen zwischen den Halbleiterscheiben kann die Oberfläche der Strukturen mit einer isolierenden Schutzschicht überzogen sein. Diese Schutzschicht ist z.B. eine thermische Oxydschicht. Es kann sich aber auch um eine passivierende Glasschicht handeln.

Die Zündung des Thyristors kann mit Hilfe von Licht erfolgen, welches in die Zwischenräume zwischen den beiden Halbleiterscheiben bzw. den parallel zueinander verlaufenden Wällen eingestrahlt oder eingestreut wird.

Am Rand oder in den Zwischenräumen zwischen den beiden Scheiben kann sich eine Lichtleitende Substanz wie z.B. Quarzpulver befinden.

Als Licht für die Zündung kann z.B. das Infrarotlicht einer GaAs-Leuchtdiode verwendet werden.

An eine Zone vom umgekehrten Leitfähigkeitstyp kann aber auch ein sperrfreier Kontakt angebracht sein, über den der Thyristor elektrisch gezündet werden kann.

Die Erfindung wird im folgenden mit 2 Ausführungsbeispielen näher beschrieben.

Ausführungsbeispiel 1 zeigt in einem Teilausschnitt einen schnellen Leistungsthyristor mit Licht-Zündung.

Ausführungsbeispiel 2 beschreibt einen Leistungsthyristor mit elektrischer Zündung.

## Ausführungsbeispiel 1

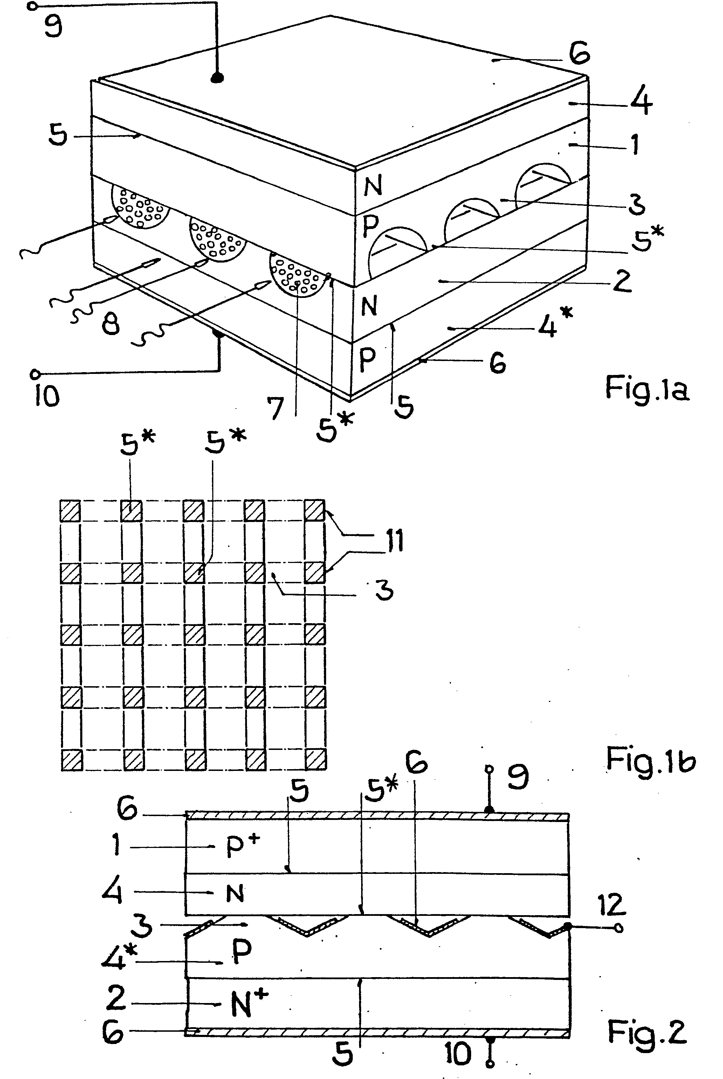

In Fig. 1 ist 1 eine planparallele 500 $\Omega$cm p-Siliziumscheibe mit einem Durchmesser von $5 \times 5$ cm$^2$ und einer Dicke von $5 \cdot 10^{-2}$ cm. Auf einer Seite dieser Scheibe 1 ist durch ganzflächige Eindiffusion von Arsen bis zu einer Tiefe von $2 \cdot 10^{-2}$ cm mit einer Oberflächenkonzentration $> 10^{20}$ Atome/cm$^3$ eine n-Zone 4 entstanden. 2 ist eine planparallele 500 $\Omega$cm n-Siliziumscheibe von $5 \times 5$ cm$^2$ Durchmesser und einer Dicke von $5 \cdot 10^{-2}$ cm. Auf einer Seite dieser Scheibe 2 ist durch ganzflächige Eindiffusion von Bor von $> 10^{20}$ Atome/cm$^3$ eine p-Zone 4* entstanden. Die Zonen 4 und 4* bilden mit dem Scheibenmaterial jeweils einen pn-Übergang 5, 5*.

Die nichtdiffundierten Oberflächenseiten der Scheiben 1 und 2 tragen eine Struktur mit parallel zueinander verlaufenden, sich zur freiliegenden Stirnfläche hin verjüngenden Wällen 3. Die Stirnfläche oder der Grat 11 der Wälle 3 hat beispielsweise eine Breite von $10^{-3}$ cm. Der Abstand der Wälle 3 von einem Grat 11 zum benachbarten Grat 11 beträgt $1 \cdot 10^{-2}$ cm. Die beiden Scheiben 1 und 2 werden bezüglich ihrer Wall-Strukturen — wie in Fig. 1a dargestellt — um 90° in der Scheibenebene gegeneinander verdreht unter mechanischem Druck so aufeinandergelegt, daß die Wälle 3 sich an ihren Gratflächen kreuzen und berühren. Bei einer Temperatur von ca. 800 °C werden die Berührungsstellen danach als Folge einer kleinen Deformation des Siliziumgitters in insgesamt $2,5 \cdot 10^5$ elektrisch parallel geschaltete p/n-Übergänge 5* umgewandelt. Danach wird die noch freiliegende Oberfläche der Wälle 3 mit einer dünnen thermischen Oxydschicht überzogen. An die Diffusionsschichten 4 und 4* beider Scheiben 1 und 2 werden schließlich sperrfreie Metallkontakte 6 angebracht. Der Anodenanschluß 9 ist an dem sperrfreien Metallkontakt 6 der Scheibe 1 und der Kathodenkontakt 10 an dem sperrfreien Metallkontakt 6 der Scheibe 2 angebracht. Durch die parallel zu den Wällen 3 erfolgende Einstrahlung von Infrarot-Licht 8 aus einer GaAs-Leucht-Diode in die Zwischenräume zwischen den Scheiben 1 und 2, die mit feinem Quarzpulver 7 gefüllt sind, zündet der Thyristor praktisch ohne Zündverzug.

Fig. 1b zeigt noch in einer Darstellung der Berührungsebene der beiden Halbleiterscheiben 1 und 2 schematisch die flächenhafte Anordnung der $2,5 \cdot 10^5$ elektrisch parallel geschalteten p/n-Übergänge 5* mit jeweils einer Fläche von $1 \cdot 10^{-6}$ cm$^2$, die durch die sich berührenden Gratflächen (11) der Wälle 3 gebildet werden.

## Ausführungsbeispiel 2

In Fig. 2 ist 1 eine p$^+$-Siliziumscheibe, auf die eine 1 $\Omega$cm n-Siliziumschicht 4 von $4 \cdot 10^{-3}$ cm Dicke epitaktisch aufgebracht ist. 2 ist eine n$^+$-Siliziumscheibe, auf welche eine 10 $\Omega$cm p-Siliziumschicht 4* von $4 \cdot 10^{-3}$ cm Dicke epitaktisch aufgebracht ist. Die Siliziumscheiben sind 1-0-0 orientiert. Beide Epitaxschichten haben eine Struktur sich verjüngender, parallel zueinander verlaufender Wälle 3, welche über einen Struktur-Ätzprozeß erzeugt wurden und sich in die Schichten 4 bzw. 4* erstrecken. Die Stirn- oder Gratflächen der Wälle haben eine Breite von $5 \cdot 10^{-4}$ cm, ihr Abstand ist $1,5 \cdot 10^{-3}$ cm. Die Scheiben 1 und 2 sind so übereinandergelegt, daß die Wälle sich kreuzen und nach einer Temperaturbehandlung an den Berührungsstellen p/n-Übergänge 5* mit einer Fläche von $2,5 \cdot 10^{-7}$ cm$^2$ entstanden sind. Vor dem Zusammenlegen der Scheiben 1 und 2 wurden die Böschungsflächen der Wälle 3 in der Struktur der Scheibe 2 über einen Maskenprozeß mit einer $5 \cdot 10^{-5}$ cm dicken Wolframschicht 6 überzogen, an welcher der Zündelektroden-Anschluß 12 angebracht ist.

Der Anodenanschluß 9 ist am sperrfreien Kontakt 6 der Scheibe 1 und der Kathodenanschluß 10 am sperrfreien Kontakt der Scheibe 2 angebracht.

## Literatur

1. S. Schäfer
« Herstellung von p/n-Übergängen durch gemeinsame plastische Verformung von p- und n-dotiertem Germanium »
Solid-State-Electronics, 11, 675-681 (1968).

## Bezugsziffern

1 p-dotierte Halbleiter-Scheibe
2 n-dotierte Halbleiter-Scheibe
3 Wall
4, 4* Zone mit umgekehrter Leitfähigkeit
5, 5* p/n-Übergang
6 sperrfreier Kontakt
7 Quarzpulver
8 Licht-Einstrahlung
9 Anodenanschluß
10 Kathodenanschluß
11 Grat eines Walls
12 Zündelektroden-Anschluß

## Ansprüche

1. Thyristor mit einem durch plastische Verformung erzeugten p/n-Übergang, dadurch gekennzeichnet, daß eine n-dotierte und eine p-dotierte einkristalline Halbleiterscheibe (1 und 2) vorgesehen sind, daß eine Seite beider Scheiben eine Zone (4 und 4*) vom jeweils umgekehrten Leitfähigkeitstyp trägt, daß beide Halbleiterscheiben (1, 2) auf einer Seite eine Struktur mit parallel zueinander verlaufenden Wällen (3) aufweisen, und daß die beiden Halbleiterscheiben (1, 2) mit ihren strukturierten Seiten unter Bildung einer pnpn-Zonenfolge so zusammengesetzt sind, daß die Wälle (3) beider Halbleiterscheiben sich kreuzen und berühren, und daß die Berührungsflächen infolge plastischer Verformungen des Halbleitergitters elektrisch parallel geschaltete p/n-Übergänge (5) bilden.

2. Thyristor nach Anspruch 1, dadurch gekennzeichnet, daß die beiden Halbleiterscheiben (1, 2) je einen sperrfreien Kontakt (6) aufweisen.

3. Thyristor nach Anspruch 1 oder 2, dadurch gekennzeichnet, daß für die Zündung des Thyristors Licht (8) vorgesehen ist, welches in den Zwischenraum zwischen den beiden Halbleiterscheiben einstrahlbar oder einstreubar ist.

4. Thyristor nach einem der vorhergehenden Ansprüche, dadurch gekennzeichnet, daß sich am Rand oder im Zwischenraum zwischen den beiden Halbleiterscheiben (1 und 2) eine Lichtleitende Substanz (7), wie z.B. Quarzpulver befindet.

5. Thyristor nach einem der vorhergehenden Ansprüche, dadurch gekennzeichnet, daß an eine an den mittleren pn-Übergang angrenzende Zone vom umgekehrten Leitfähigkeitstyp ein elektrischer Kontakt (12) angebracht ist, der den elektrischen Zündkontakt des Thyristors bildet.

6. Thyristor nach Anspruch 5, dadurch gekennzeichnet, daß der elektrische Zündkontakt aus einer Wolfram- oder Molybdän-Metallschicht besteht.

7. Thyristor nach einem der vorhergehenden Ansprüche, gekennzeichnet durch seine Verwendung als Hochfrequenz-Leistungs-Thyristor.

8. Verfahren zum Herstellen eines Thyristors nach einem der vorhergehenden Ansprüche, dadurch gekennzeichnet, daß die beiden Halbleiterscheiben zur Bildung der mittleren pn-Übergänge unter mechanischem Druck bei erhöhter Temperatur zusammengefügt werden.

9. Verfahren nach Anspruch 8, dadurch gekennzeichnet, daß die aus Wällen bestehende Struktur auf den Halbleiterscheiben (1, 2) mit Hilfe eines chemischen, elektrochemischen oder Plasma-Ätzprozesses oder auch mechanisch hergestellt wird.

10. Verfahren nach Anspruch 8 oder 9, dadurch gekennzeichnet, daß die Zone (4, 4*) vom umgekehrten Leitfähigkeitstyp mit Hilfe eines Diffusions-, Ionenimplantations- oder Epitax-Prozesses hergestellt wird.

11. Verfahren nach einem der Ansprüche 8 bis 10, dadurch gekennzeichnet, daß nach der Umwandlung der Berührungsflächen in parallel geschaltete p/n-Übergänge (5) die Oberfläche der Strukturen mit einer isolierenden Schutzschicht (7) überzogen wird.

12. Verfahren nach einem der Ansprüche 8 bis 11, dadurch gekennzeichnet, daß die Maske für das Ätzen der Struktur auf den Halbleiterscheiben auch als Maske für das Aufbringen einer Metallschicht benutzt wird.

## Claims

1. A thyristor having a p/n junction produced by means of plastic deformation, characterised in that an n-doped an a p-doped monocrystalline semiconductor lamella (1 and 2) are provided ; that one side of both lamellae has a region (4 and 4*) of the reverse type of conductivity in each case ; that both semiconductor lamellae (1, 2) have a structure with parallel ridges (3) on one side and that the two semiconductor lamellae (1, 2) with their structured sides are placed together forming a pnpn sequence of regions so that the ridges (3) of both semiconductor lamellae cross and touch ; and that the areas of contact form electrically parallel connected pn-junctions (5) as a result of plastic deformation of the semiconductor lattice.

2. A thyristor according to Claim 1, characterised in that the two semiconductor lamellae (1, 2) each have a contact (6) which does not block current flow.

3. A thyristor according to Claim 1 or 2, characterised in that light (8) is provided for firing the thyristor, which light may be radiated or distributed into the intermediate space between the two semiconductor lamellae.

4. A thyristor according to any one of the preceding claims, characterised in that a light-conductive substance (7), such as quartz powder, is located at the edge or in the intermediate space between the two semiconductor lamellae (1 and 2).

5. A thyristor according to any one of the preceding claims, characterised in that an electrical contact (12) of reverse type of conductivity is arranged on one region bordering the centre pn-junction ; the electrical contact forming the electrical firing contact of the thyristor.

6. A thyristor according to claim 5, characterised in that the electrical firing contact comprises a tungsten or molybdenum metal layer.

7. A thyristor according to one of the preceding claims, characterised by its use as a high-frequency power thyristor.

8. A method of manufacturing a thyristor according to any one of the preceding claims, characterised in that the two semiconductor lamellae are joined together in order to form the centre pn-junction via mechanical pressure at an elevated temperature.

9. A method according to claim 8, characterised in that the structure comprising ridges is produced on the semiconductor lamellae (1, 2) with the aid of a chemical, electrochemical or plasma etching process or even mechanically.

10. A method according to claims 8 or 9, characterised in that the region (4, 4*) of the reverse type of conductivity is produced with the aid of a diffusion, ion implantation or epitaxial process.

11. A method according to any one of claims 8 to 10, characterised in that the surface of the structures is coated in an insulating protective layer (7) after transforming the areas of contact into parallel connected pn-junctions (5).

12. A method according to any one of claims 8 to 11, characterised in that the mask for etching the structure on the semiconductor lamellae is also used as a mask for applying a layer of metal.

## Revendications

1. Thyristor comportant une jonction pn produite par déformation plastique et caractérisé en ce qu'une pastille semiconductrice monocristalline à dopage n et une pastille semiconductrice monocristalline à dopage p sont prévues (1, 2) ; une face de chaque pastille comporte une région (4, 4*) du type opposé ; les deux pastilles semiconductrices (1, 2) présentent d'un côté une structure de proéminences (3) parallèles ; et les deux pastilles semiconductrices (1, 2) sont assemblées par leurs côtés structurés, avec formation d'une séquence de régions pnpn, de façon que les proéminences (3) des deux pastilles se croisent et soient en contact, et que les surfaces de contact forment, par déformations plastiques du réseau semiconducteur, des jonctions pn (5) couplées électriquement en parallèle.

2. Thyristor selon revendication 1, caractérisé en ce que les deux pastilles semiconductrices (1, 2) comportent chacune un contact (6) sans tension inverse.

3. Thyristor selon une des revendications 1 et 2, caractérisé en ce qu'une lumière (8) est prévue pour l'amorçage du thyristor et introduite dans la cavité entre les deux pastilles semiconductrices par rayonnement ou dispersion.

4. Thyristor selon une quelconque des revendications 1 à 3, caractérisé par la présence d'une substance photoconductrice (7), telle que de la poudre de quartz, sur le bord ou dans la cavité entre les deux pastilles semiconductrices (1, 2).

5. Thyristor selon une quelconque des revendications 1 à 4, caractérisé en ce qu'un contact électrique (12), constituant le contact d'amorçage électrique du thyristor, est disposé sur une région de type opposé, voisine de la jonction pn médiane.

6. Thyristor selon revendication 5, caractérisé en ce que le contact d'amorçage électrique est constitué par une couche de tungstène ou de molybdène.

7. Thyristor selon une quelconque des revendications 1 à 6, caractérisé par son utilisation comme thyristor de puissance haute fréquence.

8. Procédé pour la production d'un thyristor selon une quelconque des revendications 1 à 7, caractérisé par l'assemblage des deux pastilles semiconductrices sous pression mécanique et à température élevée, pour formation des jonctions pn médianes.

9. Procédé selon revendication 8, caractérisé en ce que la structure de proéminences des plaquettes semiconductrices (1, 2) est produite par une gravure chimique, électrochimique ou au plasma, ou mécaniquement.

10. Procédé selon une des revendications 8 et 9, caractérisé en ce que la région (4, 4*) du type opposé est produite par diffusion, implantation d'ions ou épitaxie.

11. Procédé selon une quelconque des revendications 8 à 10, caractérisé en ce que la surface des structures est recouverte d'une couche protectrice isolante (7) après la transformation des surfaces de contact en jonctions pn (5) couplées en parallèle.

12. Procédé selon une quelconque des revendications 8 à 11, caractérisé en ce que le masque de gravure de la structure sur les pastilles semiconductrices est également utilisé comme mastue pour le dépôt d'une couche métallique.

Fig.1a

Fig.1b

Fig.2